# EUROPÄISCHE PATENTSCHRIFT

(11) **EP 1 352 395 B1**
(45) Veröffentlichungstag und Bekanntmachung des Hinweises auf die Patenterteilung: **02.06.2004**
(21) Anmeldenummer: 01990315.2
(22) Anmeldetag: 18.12.2001
(51) Int. Cl.: G11C 29/00

(54) **SCHALTUNGSANORDNUNG ZUR ANSTEUERUNG EINER PROGRAMMIERBAREN VERBINDUNG**
CIRCUIT ARRANGEMENT FOR TRIGGERING A PROGRAMMABLE CONNECTION
ENSEMBLE CIRCUIT POUR LA COMMANDE D'UNE LIAISON PROGRAMMABLE

(30) Priorität: 20.12.2000 DE 10063685
(43) Veröffentlichungstag der Anmeldung: 15.10.2003
(73) Patentinhaber: Infineon Technologies AG, 81669 München (DE)
(72) Erfinder: KAISER, Robert, 86916 Kaufering (DE); SCHAMBERGER, Florian, 83435 Bad Reichenhall (DE)
(74) Vertreter: Epping Hermann & Fischer
(86) Internationale Anmeldenummer: PCT/DE2001/004787
(87) Internationale Veröffentlichungsnummer: WO 2002/050839

(56) Entgegenhaltungen:
- FR-A- 2 611 400
- US-A- 5 424 672
- US-A- 5 442 589
- US-A- 5 631 862

## Beschreibung

Die vorliegende Erfindung betrifft eine Schaltungsanordnung zur Ansteuerung einer programmierbaren Verbindung gemäβ des Oberbegriff des Anspruchs 1 sowie eine Verwendung derselben in einem Massen-Speicherchip. Eine solche schaltungsanordnung ist beispielweise aus US-A-5 631 862 bekannt.

In Speicherchips, beispielsweise SD-RAMs (Synchronous Dynamic Random Access Memory), welche einen Speicherplatz von beispielsweise 256 Megabyte aufweisen, sind üblicherweise zur Bereitstellung einer Redundanz Ersatz-Speicherzellen vorgesehen, welche fertigungsbedingte Ausfälle einzelner Speicherzellen ausgleichen können. Hierfür sind programmierbare Verbindungen, welche auch als Fuses bezeichnet werden, vorgesehen, durch deren Programmierung ein Ersetzen von defekten Speicherzellen durch intakte Ersatzzellen möglich ist. In einem RAM mit einer Speicherkapazität von 256 MB können beispielsweise einige Tausend Fuses vorgesehen sein.

Zum Umschalten der programmierbaren Verbindungen von einem niederohmigen in einen hochohmigen Zustand oder umgekehrt werden die programmierbaren Verbindungen in bekannter Weise entweder mit einem Energieimpuls in Form eines Lasers oder mittels eines elektrischen Impulses dauerhaft umgeschaltet. Der elektrische Impuls kann beispielsweise ein Spannungsimpuls oder ein Stromimpuls sein.

Dabei unterscheidet man Fuses, welche mit dem beschriebenen Energieimpuls von einem leitenden (niederohmigen) in einen nicht-leitenden (hochohmigen) Zustand versetzt werden können, und Anti-Fuses, welche durch Beaufschlagen mit einem Energieimpuls von einem nicht-leitenden in einen leitenden Zustand gebracht werden können.

Dieses sogenannte Aktivieren, Brennen oder Schießen von Fuses, welches ein einmaliger, üblicherweise irreversibler Vorgang ist, mit dem die programmierbare Verbindung dauerhaft von einem niederohmigen in einen hochohmigen Zustand oder umgekehrt gebracht wird, erfolgt bisher üblicherweise mittels Laser vor einem Vergießen der Speicherchips mit einem Gehäuse. Damit ist jedoch der Nachteil verbunden, daß keine Reparatur defekter Speicherzellen nach dem Vergießen der Chips mehr möglich ist.

Beim Brennen von Fuses mit elektrischen Impulsen wird bisher üblicherweise ein flüchtiger Speicher, in dem die dauerhaft zu programmierende Information flüchtig gespeichert ist, ausgelesen und anschließend werden die zu brennenden programmierbaren Verbindungen von außen über Adressen angesprochen und ausgewählt. Dieses Vorgehen erfordert einen großen Aufwand. Zudem dauert das beschriebene Prinzip verhältnismäßig lange.

Aufgabe der vorliegenden Erfindung ist es, eine Schaltungsanordnung zur Ansteuerung einer programmierbaren Verbindung anzugeben, welche ein schnelles Ansteuern der programmierbaren Verbindung mit geringem Aufwand gestattet.

Erfindungsgemäß wird die Aufgabe gelöst von einer Schaltungsanordnung zur Ansteuerung einer programmierbaren Verbindung, aufweisend
- die programmierbare Verbindung zur dauerhaften Speicherung eines Datums,
- eine Ansteuerschaltung mit einem Ausgang, der mit der programmierbaren Verbindung gekoppelt und an dem ein Energieimpuls zum Aktivieren der programmierbaren Verbindungen in Abhängigkeit von einem an zumindest einen Daten-Eingang der Ansteuerschaltung anliegenden Daten-Signal ableitbar ist, und
- einen flüchtigen Speicher zum schnellen Speichern eines Datums, mit einem Ausgang, an dem der Speicherinhalt des flüchtigen Speichers ableitbar ist,
- wobei der Ausgang des flüchtigen Speichers mit dem zumindest einen Daten-Eingang der Ansteuerschaltung zur Datenübermittlung verbunden ist.

Die Ansteuerschaltung stellt einen Energieimpuls bereit, welcher zum Programmieren, Aktivieren oder Schießen der programmierbaren Verbindung geeignet ist. Unter Aktivieren, Programmieren oder Schießen der programmierbaren Verbindung wird dabei das dauerhafte Umschalten der programmierbaren Verbindung von einem niederohmigen in einen hochohmigen Zustand oder umgekehrt verstanden.

Derartige programmierbare Verbindungen zur dauerhaften Speicherüng eines Datums, beispielsweise eines einzigen Bit, werden üblicherweise als Fuse bezeichnet. Fuses, welche mit einem elektrischen Energieimpuls aktivierbar sind, werden auch als e-Fuse bezeichnet. Der elektrische Energieimpuls kann beispielsweise ein Strom- oder Spannungsimpuls sein.

Um in einem Massenspeicher-Chip, beispielsweise einem SD-RAM, in Echtzeit auftretende oder erkannte Fehler, das heißt fehlerhafte Speicherzellen, reparieren zu können, ist der flüchtige Speicher erforderlich, mit dem mittels Umprogrammierung defekte Speicherzellen durch redundante, intakte Zellen ersetzt werden können. Dies ist in Echtzeit üblicherweise nicht mit programmierbaren Verbindungen möglich, da das Brennen von programmierbaren Verbindungen nicht innerhalb eines Taktzyklusses erfolgen kann, welcher beispielsweise bei einer Taktrate von 100 MHz lediglich 10 ns beträgt.

Der dauerhafte Speicher, den die programmierbare Verbindung realisiert, ist vielmehr zum Speichern der Umprogrammierung, beispielsweise in Speicherchips, geeignet. Nach einem Ausschalten und WiederEinschalten eines Systems, welches einen oder mehrere Speicherchips aufweist, soll die bereits bekannte Information über Programmierungen bezüglich defekter Speicherzellen üblicherweise ohne ein erneutes Detektieren defekter Speicherzellen und deren Ersetzen durch redundante Zellen erfolgen können.

Falls eine Adresse einer fehlerhaften, zu ersetzenden Speicherzelle mehrere Bit, beispielsweise 25 Bit, umfaßt, so können, falls die beschriebene Schaltungsanordnung jeweils zum flüchtigen und dauerhaften Speichern eines einzigen Bits geeignet ist, mehrere beschriebene Schaltungsanordnungen vorgesehen sein.

Das beschriebene Prinzip ermöglicht das direkte Ansteuern einer programmierbaren Verbindung mit der Ansteuerschaltung direkt und unmittelbar durch ein im flüchtigen Speicher gespeichertes Datum. Hierdurch ergibt sich ein geringer Aufwand. Ein aufwendiges Auslesen eines flüchtigen Speichers, welcher auch als Fuse-Latch bezeichnet wird, sowie ein anschließendes Adressieren der zugeordneten programmierbaren Verbindung kann dabei entfallen. Insgesamt ist ein schnelles Brennen oder Programmieren von programmierbaren Verbindungen, insbesondere in Speicherchips, möglich.

In einer bevorzugten Ausführungsform der Erfindung ist der Ausgang des flüchtigen Speichers unmittelbar mit dem zumindest einen Dateneingang der Ansteuerschaltung verbunden. Das unmittelbare Verbinden ermöglicht zum einen einen besonders einfachen Schaltungsaufbau und zum anderen ein besonders schnelles Brennen von programmierbaren Verbindungen.

In einer weiteren, bevorzugten Ausführungsform der vorliegenden Erfindung umfaßt der flüchtige Speicher eine Speicherzelle. Die Speicherzelle kann dabei zum schnellen Speichern eines Datums ausgelegt sein. Der Ausgang des flüchtigen Speichers, der unmittelbar mit dem zumindest einen Dateneingang der Ansteuerschaltung verbunden sein kann, kann ein Ausgang der Speicherzelle sein.

In einer weiteren, bevorzugten Ausführungsform der vorliegenden Erfindung weist die Speicherzelle zwei Inverter auf, welche unter Bildung einer Selbsthaltung gegengekoppelt sind. Dabei kann je ein Eingang eines Inverters mit einem Ausgang eines anderen Inverters gekoppelt sein, dessen Eingang mit dem Ausgang des ersten Inverters gekoppelt sein kann. Hierdurch ergibt sich eine Selbsthaltung. Damit ist ein besonders einfacher Aufbau einer Speicherzelle, auch Latch genannt, möglich, welche zudem besonders schnell auslesbar und beschreibbar ist.

In einer weiteren, bevorzugten Ausführungsform der Erfindung weist die Ansteuerschaltung einen Aktivier-Eingang zum Zuführen eines Aktiviersignals und einen Daten-Eingang zum Zuführen eines Datensignals auf. Der Daten-Eingang kann, wie bereits beschrieben, mit dem Ausgang des flüchtigen Speichers verbunden sein. Zusätzlich kann ein Aktivier-Eingang vorgesehen sein, mit dem allgemein ein Auswählen oder Selektieren der mit der betreffenden Ansteuerschaltung verbundenen programmierbaren Verbindung ermöglicht ist.

In einer weiteren, bevorzugten Ausführungsform der vorliegenden Erfindung weist die Ansteuerschaltung eine UND-Logikschaltung auf, mit dem Daten-Eingang und dem Aktivier-Eingang zur UND-Verknüpfung von Datensignal und Aktiviersignal. Dabei wird ein Energieimpuls ausgangsseitig an der Ansteuerschaltung genau dann ausgegeben, wenn sowohl Datensignal als auch Aktiviersignal bei positiver Schaltungslogik jeweils eine logische Eins übermitteln.

In einer weiteren, bevorzugten Ausführungsform der vorliegenden Erfindung weist der flüchtige Speicher zusätzlich zum Ausgang einen Komplementärausgang auf, an dem ein zum am Ausgang ableitbaren Datensignal komplementäres Datensignal ableitbar ist und die Ansteuerschaltung weist zusätzlich zum zumindest einen Eingang einen Komplementäreingang auf, der mit dem Komplementärausgang verbunden ist. Eingang und Komplementäreingang sind dabei Dateneingänge. Das am Komplementäreingang bereitstellbare Signal kann ein inverses Datensignal sein. Das am Komplementärausgang ableitbare komplementäre Datensignal kann ein inverses Datensignal sein.

In einer weiteren, vorteilhaften Ausführungsform der vorliegenden Erfindung ist der Komplementäreingang unmittelbar an den Komplementärausgang angeschlossen. Zur Übertragung von komplementären Signalen kann die unmittelbare Verbindung von Dateneingang und Komplementäreingang der Ansteuerschaltung mit Ausgang und Komplementärausgang der Speicherzelle des flüchtigen Speichers ein besonders schnelles Brennen der programmierbaren Verbindung sowie einen besonders einfachen Schaltungsaufbau ermöglichen.

In einer weiteren, vorteilhaften Ausführungsform der vorliegenden Erfindung umfaßt die Ansteuerschaltung einen Brenntransistor, der eingangsseitig mit dem zumindest einen Daten-Eingang sowie mit einem Anschluß zur Zuführung einer Brennspannung und ausgangsseitig mit der programmierbaren Verbindung zur Übermittlung eines Spannungsimpulses gekoppelt ist. Der beschriebene Energieimpuls zum Brennen oder Aktivieren der programmierbaren Verbindung kann ein elektrischer Impuls, beispielsweise ein beschriebener Spannungsimpuls sein. Dieser Spannungsimpuls kann vorteilhafterweise mit dem Brenntransistor bereitgestellt sein. Beispielsweise kann an einem Steueranschluß des Brenntransistors die beschriebene UND-Logikschaltung ausgangsseitig angeschlossen sein. Ein Anschluß der gesteuerten Strecke des Brenntransistors kann mit dem Anschluß zur Zuführung einer Brennspannung, ein weiterer Anschluß des Brenntransistors kann unmittelbar mit der programmierbaren Verbindung verbunden sein.

In einer weiteren, vorteilhaften Ausführungsform der vorliegenden Erfindung weist die Ansteuerschaltung eine Pegelerhöhungsschaltung auf, die ausgangsseitig an einen Eingang des Brenntransistors angeschlossen ist. Die Pegelerhöhungsschaltung kann mit einem Eingang beispielsweise an einen Ausgang der UND-Logikschaltung angeschlossen sein. Mit der Pegelerhöhungsschaltung kann, falls zum Brennen der programmierbaren Verbindung erforderlich, eine höhere Brennspannung bereitgestellt sein. Die Pegelerhöhungsschaltung erhöht dabei den Spannungspegel, welcher eingangsseitig anliegt, und stellt ausgangsseitig einen höheren Spannungspegel bereit.

In einer weiteren, bevorzugten Ausführungsform der Erfindung ist die Schaltungsanordnung in CMOS-Schaltungstechnik aufgebaut. Dies ermöglicht einen besonders Platz sparenden, Strom sparenden und einfachen Schaltungsaufbau.

In einer weiteren, vorteilhaften Ausführungsform der vorliegenden Erfindung ist die Schaltungsanordnung in einem Massenspeicher-Chip angeordnet. Die beschriebene Schaltungsanordnung kann dabei in einer Vielzahl in dem Massenspeicher-Chip vorgesehen sein. Insbesondere können so viele Schaltungsanordnungen wie programmierbare Verbindungen vorgesehen sein. In einem SD-RAM-Speicherchip mit 512 MB Speicherplatz können beispielsweise 10.000 der beschriebenen Schaltungsanordnungen vorgesehen sein.

Weitere Einzelheiten der Erfindung sind Gegenstand der Unteransprüche.

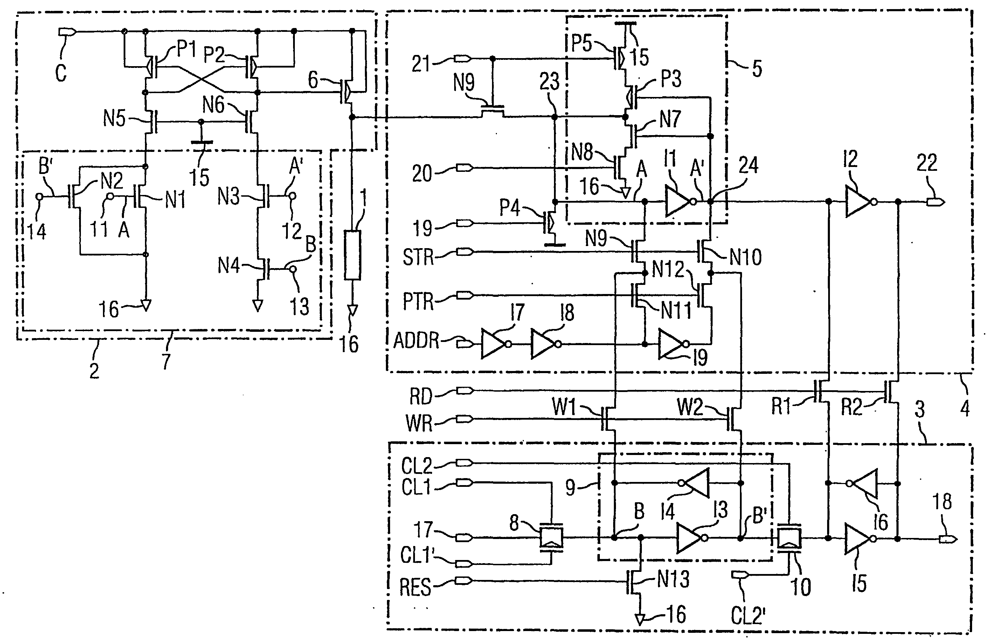

Die Erfindung wird nachfolgend an einem Ausführungsbeispiel anhand der Zeichnung näher erläutert. Es zeigt:

Die Figur ein Ausführungsbeispiel der Erfindung anhand eines vereinfachten Schaltbilds.

Die Figur zeigt eine als Antifuse ausgebildete programmierbare Verbindung 1, welche mit einem Anschluß an einen Versorgungsspannungsanschluß 16 und mit einem weiteren Anschluß an eine Ansteuerschaltung 2 angeschlossen ist. Die Ansteuerschaltung 2 ist zur Zuführung eines Aktiviersignals B, B' mit einem Schieberegister 3 verbunden. Weiterhin ist ein flüchtiger Speicher 4 vorgesehen, der zum einen zum Auslesen des Zustandes der Antifuse 1 mit dem weiteren Anschluß derselben verbunden ist und zum anderen zur Zuführung eines Datensignals A, A' an einem Dateneingang 11, 12 mit der Ansteuerschaltung 2 verbunden ist.

Die Ansteuerschaltung 2 umfaßt eine UND-Logikschaltung 7, welche Datensignal A, A' und Aktiviersignal B, B' in einer logischen UND-Verknüpfung miteinander verknüpft. Hierfür sind zwei parallelgeschaltete NMOS-Transistoren N1, N2 vorgesehen, von denen ein erster NMOS-Transistor N1 einen Steuereingang aufweist, der an einen Dateneingang 11 angeschlossen ist und ein zweiter NMOS-Transistor N2 einen Steuereingang aufweist, der zur Zuführung des Aktiviersignals B einen Aktiviereingang 14 aufweist. Weiterhin sind zur Zuführung jeweils komplementärer oder inverser Daten- und Aktiviersignale A' ,B' weitere NMOS-Transistoren N3, N4 in der UND-Logikschaltung 7 vorgesehen, welche mit ihren gesteuerten Strecken in Serie geschaltet sind, und von denen ein erster NMOS-Transistor N3 einen Steuereingang aufweist, der an einen Dateneingang 12 angeschlossen ist zur Zuführung des komplementären Datensignals A' und ein zweiter NMOS-Transistor N4 einen Steuereingang aufweist, der mit einem Aktiviereingang 13 zur Zuführung eines komplementären Aktiviersignals B' angeschlossen ist.

Die NMOS-Transistoren N1, N3 mit dem Dateneingang 11, 12 sind zugleich Teil einer Schaltung zur Pegelerhöhung, welche steuerseitig an den Brenntransistor 6 angeschlossen ist. Die Schaltung zur Pegelerhöhung, welche Teil der Ansteuerschaltung 2 ist, weist zwei kreuzgekoppelte PMOS-Transistoren P1, P2 auf, welche über weitere NMOS-Transistoren N5, N6 mit der UND-Logikschaltung 7 verbunden sind. Ausgangsseitig an der Schaltung zur Pegelerhöhung P1, P2, N5, N6 ist ein als PMOS-Transistor ausgeführter Brenntransistor 6 angeschlossen, der mit einem Lastanschluß mit der Antifuse 1 sowie mit dem flüchtigen Speicher 4 zum Auslesen des Zustands der Antifuse 1 verbunden ist.

Der flüchtige Speicher 4 umfaßt eine Speicherzelle 5, welche aus zwei miteinander verbundenen Invertern I1; P3, N7 gebildet ist. Dabei ist ein erster Inverter I1 vorgesehen, an dessen Eingang das Datensignal A ableitbar ist und an dessen Ausgang ein komplementäres oder inverses Datensignal A' ableitbar ist. Ein PMOS-Transistor P3 sowie ein NMOS-Transistor N7, deren Steuereingänge miteinander und mit dem Ausgang des ersten Inverters I1 verbunden sind, bilden den zweiten Inverter, dessen Ausgang mit dem Eingang des ersten Inverters I1 verbunden ist. Die Inverter I1 sowie P3, N7 bilden somit als Speicherzelle ein rückgekoppeltes Latch mit Selbsthaltung.

An der Speicherzelle 5 sind zum Zweck des Auslesens des aktuellen Zustands der Antifuse 1 Hilfseingänge 19, 20, 21 vorgesehen. Zunächst wird mit Hilfseingang 19 und einem daran mit seinem Steuereingang angeschlossenen PMOS-Transistor P4 zum Auslesen des Zustands der Antifuse 1 eine logische 1 in die Speicherzelle 5 geschrieben und dort selbstgehalten. Anschließend wird mit Hilfseingängen 20, 21, die zueinander komplementäre CMOS-Transistoren P5, N8 der Speicherzelle 5 ansteuern, ein Tristate-Zustand in der Speicherzelle 5 gebildet, welcher die Speicherzelle 5, insbesondere den Inverter P3, N7 hochohmig mit den Versorgungsspannungsanschlüssen 15, 16 verbindet. Zugleich wird ein ebenfalls an Hilfseingang 21 zu seiner Steuerung angeschlossener NMOS-Transistor N9, welcher zwischen einem Anschluß der Antifuse 1 und einem Eingang der Speicherzelle 5 angeschlossen ist, geöffnet. Hierdurch ist bewirkt, daß der Schaltungsknoten am Eingang des ersten Inverters I1 in der Speicherzelle 5 hochohmig bleibt, wenn die Antifuse 1 ebenfalls hochohmig ist, und in einen niederohmigen Zustand übergeht, wenn die als Antifuse ausgebildete Antifuse 1 niederohmig, das heißt bereits geschossen ist. Im letzteren Fall entlädt sich der Eingangsknoten des ersten Inverters I1, welcher das Datensignal A bereitstellt, über Transistor N9 und die in diesem Fall leitende Antifuse 1. Sobald der Zustand der Antifuse 1, das heißt, ob die Antifuse niederohmig leitend oder hochohmig ist, als logische 0 oder 1 in die Speicherzelle 5 ausgelesen ist, werden die hierfür an den Hilfseingängen 20, 21 angelegten Signale entfernt und die Speicherzelle 5 geht wieder in Selbsthaltung über. Mit einem Inverter I2, welcher an den Ausgang des ersten Inverters I1 mit seinem Eingang angeschlossen ist, kann das Datensignal A beziehungsweise das inverse Datensignal A' an einem Ausgang 22 aus Speicherzelle 5 ausgelesen werden. Weiterhin ist die Speicherzelle 5 mit einem Adresseingang ADDR gekoppelt, der eingangsseitig an drei hintereinandergeschalteten Invertern I7, I8, I9 angeschlossen ist. Zur Kopplung des Adresseingangs ADDR mit der Speicherzelle 5 sind weiterhin zwei Paare von NMOS-Transistoren N9, N10; N11, N12 vorgesehen, deren Steuereingänge mit einem Strobe-Eingang STR und mit einem Pointer-Eingang PTR verbunden. Mittels Strobe- und Pointer-Signalen auf den Auswahlleitungen Strobe STR, Pointer PTR kann ein Bit einer Adresse einer Speicherzelle beispielsweise eines SD-RAMs in die Speicherzelle 5 geschrieben werden, wobei die Speicherzelle im SD-RAM, auf die die Adresse zeigt, von der ein Bit am Eingang ADDR zuführbar ist, fehlerhaft sein kann. Ist die Adresse fehlerhaft, so kann mit Auswahlleitungen Strobe, Pointer STR, PTR, welche hierzu aktivierbar sind, das am Adress-Eingang ADDR anliegende Bit der betreffenden fehlerhaften Speicherzellenadresse in die Speicherzelle 5 geschrieben werden.

Mit Speicherzelle 5 kann jedoch, da diese lediglich einen flüchtigen Speicher bildet, keine dauerhafte Speicherung des Bits der Adresse der fehlerhaften Speicherzelle ermöglicht sein. Deshalb ist mit der beschriebenen Ansteuerschaltung 2 das Auslesen der Speicherzelle 5, das heißt des Datensignals A, A' über die bereits beschrieben UND-Steuerlogik 7 sowie das dauerhafte Speichern des ausgelesenen Datums mit dem Brenntransistor 6 in der Antifuse 1 möglich. Die UND-Logikschaltung 7 verknüpft dabei das Datensignal A, A' mit einem Aktiviersignal B, B' in einer UND-Verknüpfung. Folglich wird die Antifuse 1 nur dann gebrannt oder geschossen, wenn sowohl in Speicherzelle 5 eine logische 1 gespeichert ist, als auch zusätzlich am Aktiviereingang 13, 14 eine logische 1 durch das Aktiviersignal B, B' bereitgestellt ist. Schließlich ist für einen Brennvorgang der Antifuse 1 gemäß Ausführungsbeispiel noch erforderlich, daß eine Brennspannung C an den die bereits beschriebene Pegelerhöhungsschaltung bildenden PMOS-Transistoren P1, P2 sowie am Brenntransistor 6 anliegt.

Das Aktviersignal B, B' kann nun gemäß der vorliegenden Erfindung mit dem Schieberegister 3 in der Registerzelle 9 bereit gestellt sein, welche ebenfalls zwei gegengekoppelte Inverter I3, I4 aufweist, welche eine Selbsthalteschaltung bilden. Am Eingang der Registerzelle 9, sowie am Ausgang der Registerzelle 9 ist jeweils ein als PMOS-Transfergate ausgeführter Schalter 8, 10 angeschlossen. Während der eingangsseitig angeschlossene Schalter 8 mit einem ersten Taktsignal CL1, CL1' ansteuerbar ist, kann der ausgangsseitig angeordnete Schalter 10 mit einem zweiten Taktsignal CL2, CL2', welches dem Schalter 10 zuführbar ist, angesteuert werden. Über einen NMOS-Transistor N13, welcher den Eingang der Speicherzelle 9 mit einem Versorgungsspannungsanschluß 16 verbindet, und der steuerseitig an einen Rücksetz-Eingang RES angeschlossen ist, kann der Speicherinhalt der Registerzelle 9 zurückgesetzt werden. Ausgangsseitig an Registerzelle 9 und dem ausgangsseitigen Schalter 10 nachgeschaltet weist das Schieberegister 3 eine weitere Selbsthalteschaltung auf, welche mit zwei ebenfalls gegengekoppelten Invertern I5, I6 realisiert ist und den Schalter 10 mit einem Ausgang 18 des Schieberegisters 3 koppelt. Der Eingang des Schieberegisters 3, welcher an einen Eingang des eingangsseitigen Schalters 8 angeschlossen ist, ist mit 17 bezeichnet.

Wie bereits beschrieben, werden Speicherzellen in SD-RAM-Chips, welche beispielsweise 256 Megabyte Speicherplatz haben können, über Adressen selektiert. Eine solche Adresse kann beispielsweise 25 Bit aufweisen. Zur Adressierung einer einzelnen Speicherzelle eines SD-RAM-Chips sind demnach 25 der in der Figur gezeigten Schaltungen, umfassend Antifuse 1, Ansteuerschaltung 2, flüchtiger Speicher 4 und Schieberegister 3 erforderlich. Um beim Brennen der Antifuses 1 jedoch einen unzulässig hohen Stromfluß, welcher kurzzeitig pro Antifuse circa 1 mA betragen kann, zu vermeiden, können die einzelnen Ansteuerschaltungen 2 für die Antifuses 1 mit Schieberegister 3 nacheinander oder teilweise gleichzeitig selektiert oder angesprochen werden. Hierfür können die mehreren Schieberegister 3 in einer Serienschaltung miteinander verbunden sein, wobei jeweils ein Eingang 17 einer Schieberegisterschaltung 3 mit einen Ausgang 18 einer anderen Schieberegisterschaltung 3 verbunden sein kann. Hierdurch ist eine Schieberegisterkette gebildet. Die miteinander über Schalter 8, 10 jeweils verbunden Registerzellen 9 können auch als ein Register aufgefaßt werden. Am Eingang der ersten Registerzelle kann ein Bitmuster-Generator angeschlossen sein, der in vorliegender Figur nicht eingezeichnet ist. Darf lediglich eine Antifuse gleichzeitig gebrannt werden, so ist mit dem Bitmuster-Generator am Eingang der Schieberegisterkette eine Bitfolge bereitstellbar, welche lediglich eine logische 1 aufweist und mit Nullen aufgefüllt wird. Diese logische 1 wird nun nacheinander durch alle Registerzellen 9 des Schieberegisters geschoben, so daß jeweils mit dem jeweiligen Aktiviersignal B nur eine Ansteuerschaltung 2 zur Zeit aktiviert ist. Zur Steuerung des Ablaufes sind die Taktsignale CL1, CL1' und CL2, CL2' vorgesehen. Können mehrere Antifuses 1 gleichzeitig gebrannt werden, so können mit Schieberegister 3 selbstverständlich auch mehrere, unmittelbar aufeinander folgende Einsen oder in einem einstellbaren Abstand durch Nullen beabstandete Einsen durch die Schieberegisterkette geschoben werden.

Die beschriebene Schaltungsanordnung ermöglicht mit dem schnellen, flüchtigen Speicher 4 eine Korrektur fehlerhafter Speicherzellen in einem Massenspeicherchip in Echtzeit. Beispielsweise vor einem Ausschalten des Massenspeicherchip können die jeweiligen Adressen der fehlerhaften Speicherzellen dauerhaft geschrieben werden, wofür die Ansteuerschaltungen 2 und die Antifuse 1 vorgesehen sind. Somit ist ein Brennen von Antifuses 1 zur dauerhaften Speicherung fehlerhafter Adressen, genauer Adressen fehlerhafter Speicherzellen, ermöglicht. Dieses ist auch nach Vergießen und Umhäusen des Massenspeicherchips noch möglich, da die Antifuse 1 elektrisch ansteuerbar ist. Schließlich bietet die Erfindung den Vorteil, daß nicht nur ein unzulässig hoher Brennstrom durch gleichzeitiges Brennen zu vieler Antifuses auftreten kann, sondern daß zudem durch beliebig generierbare und durch die Registerzellen 9 schiebbare Bitmuster eine beliebige Anzahl Antifuses 1 gleichzeitig sowie in beliebiger Reihenfolge gebrannt werden können.

An einen Lese-Eingang RD sind weiterhin die Steueranschlüsse zweier Lesetransistoren R1, R2 angeschlossen. Dabei koppelt die gesteuerte Strecke des ersten Lesetransistors R1 den Eingang der weiteren Speicherzelle I5, I6 des Schieberegisters 3 mit dem Eingang des zweiten Inverters I2 am Ausgang der Speicherzelle 5. Der zweite Lesetransistor R2 koppelt mit seiner gesteuerten Strecke den Ausgang der weiteren Speicherzelle I5, I6 des Schieberegisters 3 mit dem Ausgang des zweiten Inverters I2 und damit dem Ausgang 22 des flüchtigen Speichers 4. Bei Aktivieren der Leseleitung am Lese-Eingang RD können somit in einfacher Weise die in der Speicherzelle 5 gespeicherten Daten beziehungsweise das in Speicherzelle 5 gespeicherte Bit ausgelesen und in das in Selbsthaltung betriebene Latch I5, I6 geschrieben werden. Zur Datenübertragung in umgekehrter Richtung ist an einen Schreib-Eingang WR je ein Steuereingang je eines ersten und zweiten Schreib-Transistors W1, W2 angeschlossen, die ebenso wie die Lesetransistoren R1, R2 als NMOS-Transistoren ausgebildet sind. Dabei koppelt die gesteuerte Strecke des ersten Schreib-Transistors W1 den Eingang der Registerzelle 9 mit einem Eingang der Speicherzelle 5 und der zweite Schreib-Transistor W2 koppelt mit seiner gesteuerten Strecke den Ausgang der Registerzelle 9 des Schieberegisters 3 mit einem Eingang der Speicherzelle 5 im flüchtigen Speicher 4.

Mit den beschriebenen Schreib- und Lese-Transistoren ist in einfacher Weise eine Kopplung zur bidirektionalen Datenübertragung zwischen Speicherzelle 5 und Registerzelle 9, das heißt zwischen flüchtigem Speicher 4 und Schieberegister 3 bewirkt. Bei besonders geringem Flächenbedarf erfüllt das Schieberegister 3 somit eine Doppelfunktion: zum einen ist ein einfaches und schnelles Auslesen und Beschreiben der Speicherzelle 5 möglich, und zum anderen ist mit dem Schieberegister eine Information zum Aktivieren des Brenntransistors 6 zum Brennen der als Antifuse ausgebildeten programmierbaren Verbindung 1 übermittelbar.

### Bezugszeichenliste

- A, A': Datensignal
- ADDR: Adress-Eingang
- B, B': Aktiviersignal
- C: Brennspannung
- CL1, CL1': Taktsignal
- CL2, CL2': Taktsignal
- I1 bis 19: CMOS-Inverter
- N1 bis N13: NMOS-Transistor
- P1 bis P5: PMOS-Transistor
- PTR: Pointer-Eingang
- RD: Lese-Eingang
- WR: Schreib-Eingang
- RES: Rücksetz-Eingang
- R1: Lesetransistor
- R2: Lesetransistor
- STR: Strobe-Eingang
- 1: Programmierbare Verbindung
- 2: Ansteuerschaltung
- 3: Schieberegister
- 4: Flüchtiger Speicher
- 5: Speicherzelle
- 6: Brenntransistor
- 7: Und-Logikschaltung
- 8: Schalter
- 9: Registerzelle
- 10: Schalter
- 11, 12: Dateneingang
- 13, 14: Aktiviereingang
- 15: Versorgungsspannungsanschluß
- 16: Versorgungsspannungsanschluß
- 17: Eingang
- 18: Ausgang
- 19, 20, 21: Hilfseingang
- 22: Ausgang
- 23: Ausgang
- 24: Ausgang

## Patentansprüche

1. Schaltungsanordnung zur Ansteuerung einer programmierbaren Verbindung (1), aufweisend
- die programmierbare Verbindung (1) zur dauerhaften Speicherung eines Datums,
- eine Ansteuerschaltung (2) mit einem Ausgang, der mit der programmierbaren Verbindung (1) gekoppelt und an dem ein Energieimpuls zum Aktivieren der programmierbaren Verbindungen (1) in Abhängigkeit von einem an zumindest einem Daten-Eingang (11) der Ansteuerschaltung (2) anliegenden Daten-Signal (A) ableitbar ist, und
wobei das Datensignal (A) dem Steueranschluß eines ersten Transistors (N1) der Ansteuerschaltung (2) zugeführt wird
- einen flüchtigen Speicher (4) zum Speichern eines Datums, mit einem Ausgang (23), an dem der Speicherinhalt des flüchtigen Speichers (4) ableitbar ist,
- wobei der Ausgang (23) des flüchtigen Speichers (4) mit dem zumindest einen Daten-Eingang (11) der Ansteuerschaltung (2) zur Datenübermittlung verbunden ist und wobei der flüchtige Speicher (4) zusätzlich zum Ausgang (23) einen Komplementärausgang (24) aufweist, an dem ein zum am Ausgang (23) ableitbaren Datensignal (A) komplementäres Datensignal (A') ableitbar ist, und daß die Ansteuerschaltung (2) zusätzlich zum zumindest einem Eingang (11) einen Komplementäreingang (12) aufweist, der mit dem Komplementärausgang (24) verbunden ist, **dadurch gekennzeichnet, daß** das komplementäre Datensignal (A') dem Steueranschluß (12) eines zweiten Transistors (N3) der Ansteuerschaltung (2) zugeführt wird.

2. Schaltungsanordnung nach Anspruch 1,
**dadurch gekennzeichnet, daß**
der Ausgang (23) des flüchtigen Speichers (4) unmittelbar mit dem zumindest einen Daten-Eingang (11) der Ansteuerschaltung (2) verbunden ist.

3. Schaltungsanordnung nach Anspruch 1 oder 2,
**dadurch gekennzeichnet, daß**
der flüchtige Speicher (4) eine Speicherzelle (5) umfaßt.

4. Schaltungsanordnung nach Anspruch 3,
**dadurch gekennzeichnet, daß**
die Speicherzelle (5) zwei Inverter (I1, P3, N7) aufweist, welche unter Bildung einer Selbsthaltung gegengekoppelt sind.

5. Schaltungsanordnung nach einem der Ansprüche 1 bis 4,
**dadurch gekennzeichnet, daß**
die Ansteuerschaltungen (2) einen Aktiviereingang (13) zum zuführen eines Aktiviersignals (B) und den Daten-Eingang (11) zum Zuführen des Datensignals (A) aufweist.

6. Schaltungsanordnung nach Anspruch 5,
**dadurch gekennzeichnet, daß**
die Ansteuerschaltung (2) eine UND-Logikschaltung (7) aufweist mit dem Daten-Eingang (11) und dem Aktivier-Eingang (13) zur UND-Verknüpfung von Datensignal (A) und Aktiviersignal (B).

7. Schaltungsanordnung nach einem der Ansprüche 1 bis 6,
**dadurch gekennzeichnet, daß**
der Komplementäreingang (12) unmittelbar an den Komplementärausgang (24) angeschlossen ist.

8. Schaltungsanordnung nach einem der Ansprüche 1 bis 7,
**dadurch gekennzeichnet, daß**
die Ansteuerschaltung (2) einen Brenntransistor (6) umfaßt, der eingangsseitig mit dem zumindest einen Daten-Eingang (11) sowie mit einem Anschluß zur Zuführung einer Brennspannung (C) und ausgangsseitig mit der programmierbaren Verbindung (1) zur Übermittlung eines Spannungsimpulses gekoppelt ist.

9. Schaltungsanordnung nach Anspruch 8,
**dadurch gekennzeichnet, daß**
die Ansteuerschaltung (2) eine Pegelerhöhungsschaltung (P₁, P2, N1, N3, N5, N6) aufweist, die ausgangsseitig an einen Eingang des Brenntransistors (6) angeschlossen ist.

10. Schaltungsanordnung nach einem der Ansprüche 1 bis 9,
**dadurch gekennzeichnet, daß**
die Schaltungsanordnung in CMOS-Schaltungstechnik aufgebaut ist.

11. Verwendung einer oder mehrerer Schaltungsanordnungen nach einem der Ansprüche 1 bis 10,
in einem Massenspeicher-Chip.

## Claims

1. Circuit arrangement for driving a programmable link (1), having
- the programmable link (1) for the permanent storage of a datum,
- a drive circuit (2) having an output, which is coupled to the programmable link (1) and at which can be derived an energy pulse for activating the programmable links (1) in a manner dependent on a data signal (A) present at at least one data input (11) of the drive circuit (2), and the data signal (A) being fed to the control terminal of a first transistor (N1) of the drive circuit (2),
- a volatile memory (4) for storing a datum, having an output (23), at which the memory content of the volatile memory (4) can be derived,
- the output (23) of the volatile memory (4) being connected to the at least one data input (11) of the drive circuit (2) for the purpose of data communication and the volatile memory (4) having, in addition to the output (23), a complementary output (24), at which can be derived a data signal (A') that is complementary to the data signal (A) that can be derived at the output (23), and the drive circuit (2) having, in addition to the at least one input (11), a complementary input (12) connected to the complementary output (24),
**characterized in that** the complementary data signal (A') is fed to the control terminal (12) of a second transistor (N3) of the drive circuit (2).

2. Circuit arrangement according to Claim 1,
**characterized in that**
the output (23) of the volatile memory (4) is directly connected to the at least one data input (11) of the drive circuit (2).

3. Circuit arrangement according to Claim 1 or 2,
**characterized in that**
the volatile memory (4) comprises a memory cell (5).

4. Circuit arrangement according to Claim 3,
**characterized in that**
the memory cell (5) has two inverters (I1, P3, N7), which are coupled with negative feedback to form a self-latching.

5. Circuit arrangement according to one of Claims 1 to 4,
**characterized in that**
the drive circuit (2) has an activation input (13) for feeding in an activation signal (B) and the data input (11) for feeding in the data signal (A).

6. Circuit arrangement according to Claim 5,
**characterized in that**
the drive circuit (2) has an AND logic circuit (7), with the data input (11) and the activation input (13) for the AND combination of data signal (A) and activation signal (B).

7. Circuit arrangement according to one of Claims 1 to 6,
**characterized in that**
the complementary input (12) is directly connected to the complementary output (24).

8. Circuit arrangement according to one of Claims 1 to 7,
**characterized in that**
the drive circuit (2) comprises a blowing transistor (6), which, on the input side, is coupled to the at least one data input (11) and also to a terminal for feeding in a blowing voltage (C) and, on the output side, is coupled to the programmable link (1) for the purpose of communicating a voltage pulse.

9. Circuit arrangement according to Claim 8,
**characterized in that**
the drive circuit (2) has a level boosting circuit (P1, P2, N1, N3, N5, N6), which, on the output side, is connected to an input of the blowing transistor (6).

10. Circuit arrangement according to one of Claims 1 to 9,
**characterized in that**
the circuit arrangement is constructed using CMOS circuit technology.

11. The use of one or more circuit arrangements as claimed in one of Claims 1 to 10,
in a mass memory chip.

## Revendications

1. Montage de commande d'une liaison (1) programmable, comportant
- la liaison (1) programmable pour la mémorisation permanente d'une donnée,
- un circuit (2) de commande ayant une sortie qui est couplée à la liaison (1) programmable et de laquelle peut être sortie une impulsion d'énergie pour l'activation des liaisons (1) programmables en fonction d'un signal (A) de données s'appliquant à au moins une entrée (11) de données du circuit (2) de commande et dans lequel le signal (A) de données est envoyé à la borne de commande d'un premier transistor (N1) du circuit (2) de commande,
- une mémoire (4) volatile de mémorisation d'une donnée, ayant une sortie (23) de laquelle le contenu de la mémoire (4) volatile peut être sorti,
- dans lequel la sortie (23) de la mémoire (4) volatile est reliée à la au moins une entrée (11) de données du circuit (2) de commande pour la transmission de données et dans lequel la mémoire (4) volatile a, en plus de la sortie (23), une sortie (24) complémentaire de laquelle peut être sorti un signal (A') de données complémentaire du signal (A) de données qui peut être sorti de la sortie (23) et en ce que le circuit (2) de commande a, en plus d'au moins une entrée (11), une entrée (12) complémentaire qui est reliée à la sortie (24) complémentaire, **caractérisé en ce que** le signal (A') de données complémentaire est envoyé à la borne (12) de commande d'un deuxième transistor (N3) du circuit (2) de commande.

2. Montage suivant la revendication 1,
**caractérisé en ce que** la sortie (23) de la mémoire (4) volatile est reliée directement à la au moins une entrée (11) de données du circuit de commande.

3. Montage suivant la revendication 1 ou 2,
**caractérisé en ce que** la mémoire (4) volatile comprend une cellule (5) de mémoire.

4. Montage suivant la revendication 3,
**caractérisé en ce que** la cellule (5) de mémoire a deux inverseurs (l1, P3, N7) qui sont couplés en réaction avec formation d'un auto-maintien.

5. Montage suivant l'une des revendications 1 à 4,
**caractérisé en ce que** les circuits (2) de commande ont une entrée (13) d'activation pour l'envoi d'un signal (B) d'activation et l'entrée (11) de données pour l'envoi du signal (A) de données.

6. Montage suivant la revendication 5,
**caractérisé en ce que** le circuit (2) de commande a un circuit (7) logique ET ayant l'entrée (11) de données et l'entrée (13) d'activation pour combiner suivant la logique ET le signal (A) de données et le signal (B) d'activation.

7. Montage suivant l'une des revendications 1 à 6,
**caractérisé en ce que** l'entrée (12) complémentaire est raccordée directement à la sortie (24) complémentaire.

8. Montage suivant l'une des revendications 1 à 7,
**caractérisé en ce que** le circuit (2) de commande comprend un transistor (6) d'amorçage qui, du côté entrée, est couplé à la au moins une entrée (11) de données ainsi qu'à une borne pour l'application d'une tension (C) d'amorçage et, du côté sortie, à la liaison (1) programmable pour la transmission d'une impulsion de tension.

9. Montage suivant la revendication 8,
**caractérisé en ce que** le circuit (2) de commande comprend un circuit (P1, P2, N1, N3, N5, N6) d'augmentation du niveau, qui est raccordé du côté sortie à une entrée du transistor (6) d'amorçage.

10. Montage suivant l'une des revendications 1 à 9,
**caractérisé en ce que** le montage est constitué en technique de circuit CMOS.

11. Utilisation d'un ou plusieurs montages suivant l'une des revendications 1 à 10, dans une puce à mémoire de masse.
